# EUROPEAN PATENT APPLICATION

(11) **EP 0 887 436 A1**
(43) Date of publication of application: **30.12.1998**
(21) Application number: 98111626.2
(22) Date of filing: 24.06.1998
(51) Int. Cl.: C23C 16/30, C23C 16/34

(54) **Method and apparatus for growth of a nitride III-V compound semiconductor**

(30) Priority: 25.06.1997 JP 168553/97
(71) Applicant: SONY CORPORATION, Tokyo (JP)
(72) Inventor: Asatsuma, Tsunenori, Shinagawa, Tokyo (JP); Hashimoto, Shigeki, Shinagawa, Tokyo (JP); Nakamura, Fumihiko, Shinagawa, Tokyo (JP); Yanashima, Katsunori, Shinagawa, Tokyo (JP); Ikeda, Masao, Shinagawa, Tokyo (JP)
(74) Representative: Müller, Frithjof E., Dipl.-Ing.

(57) **Abstract**

It is intended to provide a method and apparatus for growing a high-quality nitride III-V compound semiconductor efficiently. A nitride III-V compound semiconductor, such as GaN or InGaN, is grown in a reaction tube of a MOCVD apparatus by setting the inner pressure of the reaction tube to a value not lower than 1.1 atmospheres, particularly, not lower than 1.1 atmospheres and not higher than two atmospheres, and more preferably not lower than 1.2 atmospheres and not higher than 1.8 atmospheres. The reaction tube is made of quartz glass or another material which is sufficiently resistive against a difference between inner and outer pressures.

## Description

### BACKGROUND OF THE INVENTION

### Field of the Invention

This invention relates to a method and apparatus for growing a nitride III-V compound semiconductor, in particular, using metal-organic chemical vapor deposition.

### Description of the Related Art

Nitride III-V compound semiconductors represented by gallium nitride (GaN) are hopeful materials of light emitting devices capable of emitting light in the range from green to blue, and further to the range of ultraviolet, and of high-frequency electronic devices and anti-environmental electronic devices. Especially, GaN semiconductors are greatly remarked since light emitting diodes (LED) using GaN semiconductors were brought into practice. There are some reports on realization of semiconductor lasers using GaN semiconductors, and applications thereof to optical disc devices are expected.

For manufacturing light emitting devices or electronic devices using GaN semiconductors, some GaN semiconductors must be stacked in multiple layers on a sapphire substrate or a SiC substrate. Among some methods for growing GaN semiconductors, such as metal-organic chemical vapor deposition (MOCVD) and molecular beam epitaxy (MBE), MOCVD does not require high vacuum, and is therefore practically advantageous and used most.

In a conventional method for growing a GaN semiconductor by MOCVD, while holding the inner pressure of a reaction tube of a MOCVD apparatus in atmospheric pressure (one atmosphere) or a reduced pressure (less than one atmosphere), source materials, such as gallium (Ga), aluminum (Al) and indium (In), depending on the GaN semiconductor to be grown, are supplied into the reaction tube together with a carrier gas, and also a source material of nitrogen represented by ammonia (NH₃) is simultaneously supplied into the reaction tube, so as to grow a GaN semiconductor on a substrate set in the reaction tube.

However, due to a high saturation vapor pressure of the GaN semiconductor and a low efficiency of ammonia or other nitrogen source material in emitting nitrogen atoms by decomposition, among others, nitrogen is liable to vaporize from the GaN semiconductor film under growth. Consequently, the GaN semiconductor film contains an insufficient amount of nitrogen, and largely degrades in quality.

### OBJECTS AND SUMMARY OF THE INVENTION

It is therefore an object of the invention to provide a method and apparatus for growing a nitride III-V compound semiconductor, which overcomes the problem of insufficient nitrogen and can efficiently grow a high-quality nitride III-V compound semiconductor.

To solve the problems involved in the conventional technologies, the Inventors made researches and studies explained below.

Although a GaN semiconductor was conventionally grown by setting the inner pressure of a reaction tube of a MOCVD apparatus to atmospheric pressure or a reduced pressure, here is proposed to intentionally increase the pressure in the reaction tube higher than one pressure for growth. Then, so much as the pressure in the reaction tube is increased, a larger amount of nitrogen source material is supplied onto the substrate, and vaporization of nitrogen from the GaN semiconductor film under growth is suppressed. Therefore, the problem of insufficient nitrogen is overcome, and a high-quality GaN semiconductor film is obtained.

In this case, the inner pressure of the reaction tube is preferably set to 1.1 atmospheres or more to ensure the effect by the increase in the pressure in the reaction tube. This is because, in a typical atmospheric MOCVD apparatus in which the exhaust end of the reaction tube is opened to the atmosphere, the pressure in the reaction tube is higher than the atmospheric pressure by tens of Torr due to a pressure loss in its exhaust pipes or detoxifier. Taking it into account, a pressure not lower than 1.1 atmospheres, with a slight allowance, is recommended as the pressure in the reaction tube.

Needless to say, there is an upper limit in the pressure in the reaction tube, depending on the strength and other factors of the reaction tube used. However, there is large room for choice of the pressure in the range not less than 1.1 atmospheres. Although the pressure in the reaction tube can theoretically be increased to approximately 9 atmospheres equal to the vapor pressure of ammonia usable as the nitrogen source material at an ordinary temperature, it is preferably not higher than two atmospheres mainly because the effect obtained by increasing the pressure tends to saturate under a pressure higher than two atmospheres, and the pressure of two atmospheres is considered practical and maximum when using a quartz reaction tube.

The present invention is based on these researches and knowledge of the Inventors.

That is, according to the invention, there is provided a method for growing a nitride III-V compound semiconductor by metal-organic chemical vapor deposition, comprising:
growing the nitride III-V compound semiconductor in a reaction tube whose inner pressure is set to a value not lower than 1.1 atmospheres.

According to the invention, there is also provided an apparatus for growing a nitride III-V compound semiconductor by metal-organic chemical vapor deposition, characterized in:
the nitride III-V compound semiconductor being grown in a reaction tube whose inner pressure is set to a value not lower than 1.1 atmospheres.

Typically, the nitride III-V compound semiconductor is grown in the reaction tube by setting its inner pressure to a value not lower than 1.1 atmospheres and not higher than two atmospheres. In order to ensure safe growth while promising the effect by increasing the pressure in the reaction tube, the inner pressure of the reaction tube is preferably set to a value not lower than 1.2 atmospheres and not higher than 1.8 atmospheres, more preferably to a value not lower than 1.4 atmospheres and not higher than 1.8 atmospheres, and further preferably to a value not lower than 1.6 atmospheres and not higher than 1.8 atmospheres during the growth.

The surface of the substrate on which the nitride III-V compound semiconductor is grown may be oriented either upward (including aslant upward orientations) or downward (including aslant downward orientations). However, when the substrate surface is oriented downward, an ascending current toward the substrate surface is generated in the reaction tube by thermal convection, and results in more efficient supply of the source gas to around the substrate surface and in increasing the growth rate.

The nitride III-V compound semiconductor contains at least one group III element selected from the group consisting of Ga, Al, In and B, and at least N, and may additionally contain a group V element such as As or P where appropriate. Examples of such nitride III-V compound semiconductors are GaN, AlN, InN, AlGaN, GaInN, AlGaInN, and so forth.

According to the invention configured to grow a nitride III-V compound semiconductor in a reaction tube whose inner pressure is set to a value not lower than 1.1 atmospheres, a more amount of nitrogen source material as much as the increase of the pressure in the reaction tube is supplied onto the substrate, and vaporization of nitrogen from the nitride III-V compound semiconductor film grown on the substrate is suppressed as compared with the conventional growth in a reaction tube set to atmospheric pressure or a reduced pressure. Therefore, the problem of insufficient nitrogen in a nitride III-V compound GaN semiconductor film can be removed.

The above, and other, objects, features and advantage of the present invention will become readily apparent from the following detailed description thereof which is to be read in connection with the accompanying drawings.

### BRIEF DESCRIPTION OF THE DRAWINGS

Fig. 1 is a schematic diagram showing a MOCVD apparatus as a first example usable in a process for growing a GaN semiconductor according to an embodiment of the invention;
Fig. 2 is a schematic diagram showing a MOCVD apparatus as a second example usable in a process for growing a GaN semiconductor according to the embodiment of the invention;
Fig. 3 is a schematic diagram showing a MOCVD apparatus as a third example usable in a process for growing a GaN semiconductor according to the embodiment of the invention;
Fig. 4 is a schematic diagram showing a MOCVD apparatus as a fourth example usable in a process for growing a GaN semiconductor according to the embodiment of the invention;
Fig. 5 is a schematic diagram showing a MOCVD apparatus as a fifth example usable in a process for growing a GaN semiconductor according to the embodiment of the invention;
Fig. 6 is a schematic diagram showing a MOCVD apparatus as a sixth example usable in a process for growing a GaN semiconductor according to the embodiment of the invention;
Fig. 7 is a schematic diagram showing a result of photoluminescent spectral measurement at 77K on GaN films grown by setting the pressure in the reaction tube of a MOCVD apparatus to 1.2 atmospheres and 0.33 atmospheres, respectively;
Fig. 8 is a schematic diagram showing changes in In composition x in InₓGa₁₋ₓN with the In/(Ga+In) supplied mol radio in samples prepared by setting the pressure in the reaction tube of a MOCVD apparatus to 1.2 atmospheres and 0.33 atmospheres, respectively;
Fig. 9 is a schematic diagram showing a result of measurement of Mg atom concentrations by secondary ion mass spectrometry in Mg-doped GaN grown by setting the pressure in the reaction tube of a MOCVD apparatus to 1.2 atmospheres and 0.33 atmospheres, respectively;
Fig. 10 is a schematic diagram showing a result of measurement of etch-pit densities depending upon the growth pressure on GaN samples grown by setting the pressure in the reaction tube of the MOCVD apparatus to 1.0, 1.4 and 1.6 atmospheres, respectively;
Fig. 11 is a schematic diagram showing a result of measurement of threshold power densities depending upon the growth pressure on Si-doped GaN samples grown by setting the pressure in the reaction tube of the MOCVD apparatus to 1.0 and 1.4 atmospheres, respectively;
Fig. 12 is a schematic diagram for explaining a method of measurement of threshold power densities shown in Fig. 11;
Fig. 13 is a cross-sectional view for explaining a method for growing GaN semiconductors according to an embodiment of the invention employed to manufacture a GaN semiconductor laser;
Fig. 14 is a schematic diagram of a MOCVD apparatus used for growth of GaN semiconductors holding a substrate to orient its surface downward in an embodiment of the invention;
Fig. 15 is a cross-sectional view showing a first mode of fixing the substrate onto the lower surface of a susceptor to orient the substrate surface downward;
Fig. 16 is a cross-sectional view showing a second mode of fixing the substrate onto the lower surface of the susceptor to orient the substrate surface downward;
Fig. 17 is a cross-sectional view showing a third mode of fixing the substrate onto the lower surface of the susceptor to orient the substrate surface downward;
Fig. 18 is a perspective view showing the third mode of fixing the substrate onto the lower surface of a susceptor to orient the substrate surface downward;
Fig. 19 is a cross-sectional view showing a fourth mode of fixing the substrate onto the lower surface of the susceptor to orient the substrate surface downward; and
Fig. 20 is a cross-sectional view for explaining an example of growth by holding the substrate to orient its surface obliquely downward.

### DETAILED DESCRIPTION OF THE PREFERRED EMBODIMENTS

Explained below is an embodiment of the invention with reference to the drawings. In all figures showing the embodiment, the same or equivalent elements are labeled with common reference numerals.

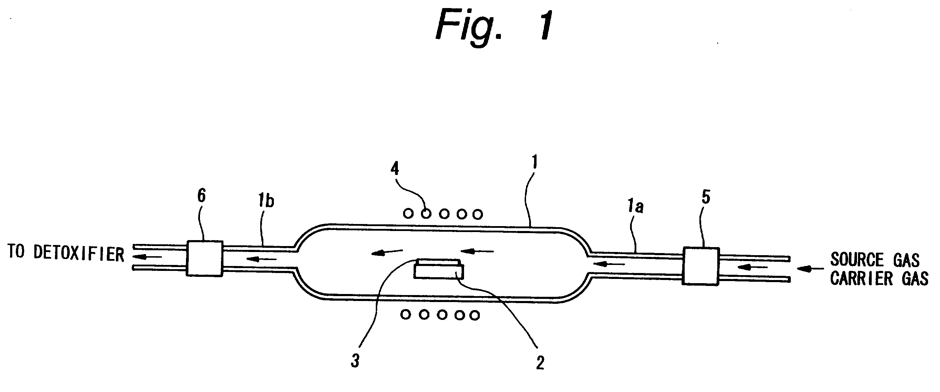

First explained are MOCVD apparatuses usable for growth of a GaN semiconductor according to the embodiment of the invention. Figs. 1 through 6 show examples of the MOCVD apparatus.

In the MOCVD apparatus shown in Fig. 1, a reaction tube 1 has a sufficient strength, and is made of a thermally stable material, such as quartz glass. The wall of the reaction tube 1 has a sufficient thickness that can resist against a pressure difference from the outside pressure, namely the atmospheric pressure, even when the inner pressure of the reaction tube 1 is increased to two atmospheres. A susceptor 2 made of graphite, for example, is provided in the reaction tube 1, to support a substrate 3 for growth. A RF coil 4 is provided outside the reaction tube 1 to surround it so that the susceptor 2 is heated due to induction heating by the RF coil 4 and results in heating the substrate 3.

The reaction tube 1 has a gas inlet 1a at one end and a gas outlet 1b at the other end. A source material gas and a carrier gas are supplied into the reaction tube 1 through the gas inlet 1a, then exhausted from the reaction tube 1 through the gas outlet 1b and sent to a detoxifier (not shown). A pressure adjuster 5 is provided in the gas inlet 1a, and a pressure adjuster 6 is provided in the gas outlet 1b.

The pressure adjuster 5 is a part for maintaining an appropriate pressure in its downstream portion. Usable as the pressure adjuster 5 is any of a regulator, a pressure controller combining a valve and a pressure sensor to control the pressure, a mass flow controller controlling the flow amount of a gas to indirectly control the pressure, a needle valve and a piezo valve, for example. The pressure adjuster 6 is used to maintain a high pressure in its upstream portion and to stabilize the pressure in the proximity of the substrate 3 on the susceptor 2 by adjusting the cross-sectional area of the passage permitting the gas to flow. Usable as the pressure adjuster 6 is any of a needle valve, butterfly valve, piezo valve, thermal valve, electromagnetic valve, and so on. By using these pressure adjusters 5 and 6 and by appropriately adjusting the flow amount of the source gas and the carrier gas supplied into the reaction tube, a predetermined high pressure can be maintained in the reaction tube 1.

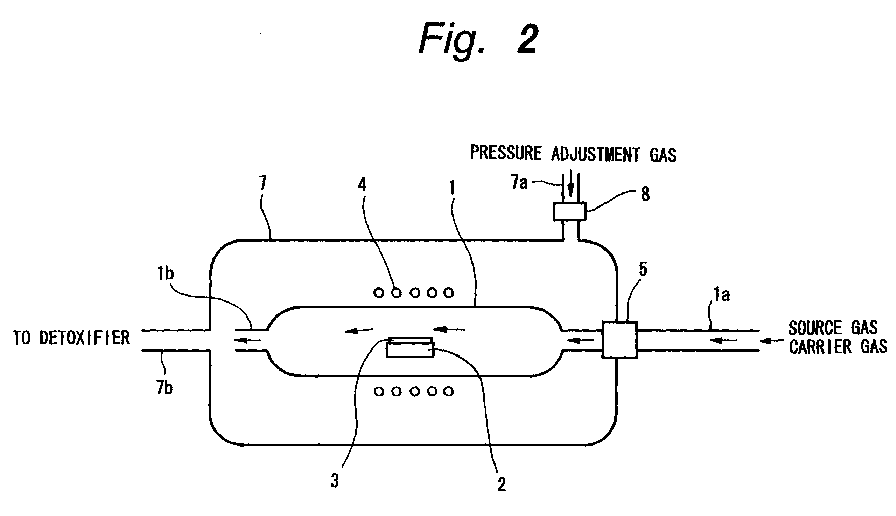

In the MOCVD apparatus shown in Fig. 2, the reaction tube 1 in the MOCVD apparatus shown in Fig. 1 is fully surrounded by a container 7 to exhibit a double structure when viewed externally. The wall of the container 7 is made sufficiently thick of a sufficiently strong material, such as quartz glass or stainless steel, to resist against the pressure difference from the outside pressure, namely the atmospheric pressure, even when the inner pressure of the container 7 is increased to two atmospheres. The inner pressure of the container 7 can be adjusted to any value not lower than 1.1 atmospheres and not higher than two atmospheres by introducing nitrogen gas or inactive gas into the container 7 from a pressure adjusting gas inlet 7a. Consequently, even when the inner pressure of the reaction tube 1 is set to a value not lower than 1.1 atmospheres and not higher than two atmospheres, the inner pressure of the container 7 can be adjusted to a pressure equal to or slightly lower than the inner pressure of the reaction tube 1 to prevent the reaction tube 1 from bursting due to a relatively higher inner pressure in the reaction tube 1 and to ensure a stable flow of the source gas into the reaction tube 1. In this case, therefore, the wall of the reaction tube 1 itself need not be as thick as the reaction tube 1 of the MOCVD apparatus shown in Fig. 1.

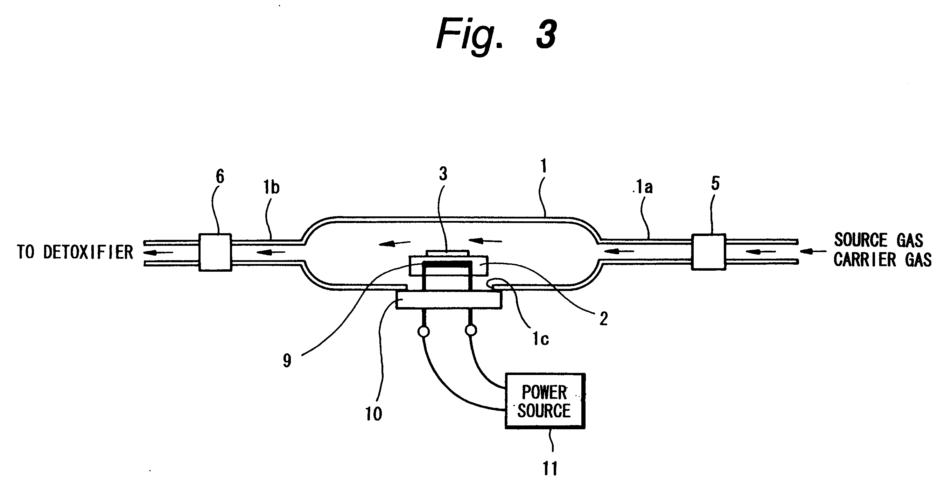

In the MOCVD apparatus shown in Fig. 3, the susceptor 2 is heated by a heater 9 whereas the susceptor 2 in the MOCVD apparatus shown in Fig. 1 or 2 is heated by induction heating using the RF coil 4. In this case, the reaction tube 1 has an aperture 1c in a lower portion of its wall in alignment with the susceptor 2, and a high pressure-resistant flange 10 is attached to overlap the aperture 1c. The high pressure-resistant flange 10 is made of a sufficiently strong material, such as stainless steel, to resist against a pressure difference between inside and outside the reaction tube 1. The heater 9 is mounted to the high pressure-resistant flange 10 and connected to a heater power source 11.

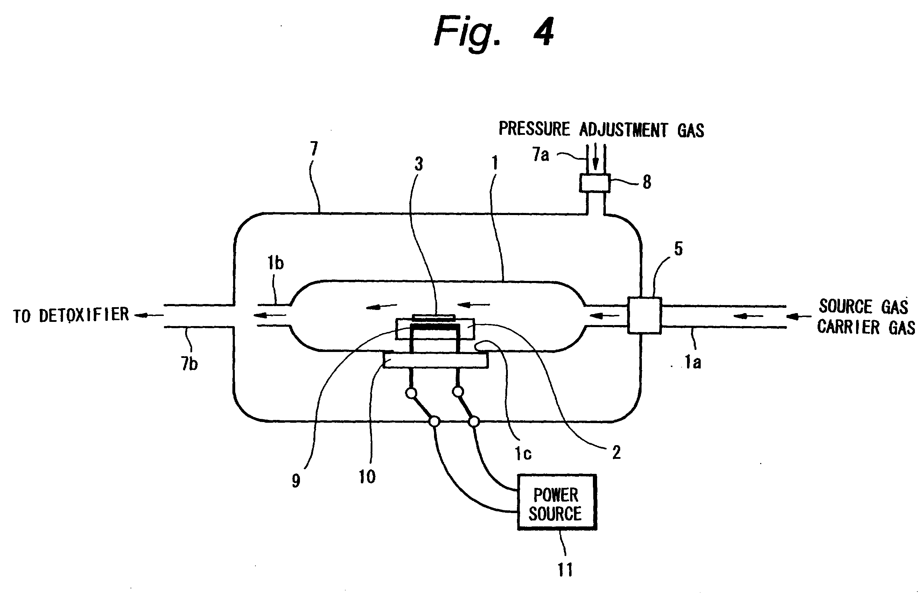

In the MOCVD apparatus shown in Fig. 4, the reaction tube 1, as used in the MOCVD apparatus shown in Fig. 3, is fully surrounded by the container 7 to exhibit a double structure when viewed externally, similarly to the MOCVD apparatus shown in Fig. 2.

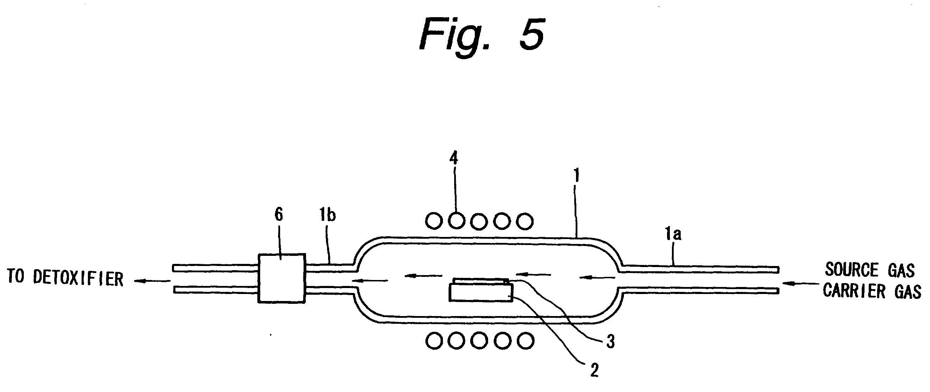

The MOCVD apparatus shown in Fig. 5 is different from the MOCVD apparatus shown in Fig. 1 in having no pressure adjuster 5 in the gas inlet 1a, but otherwise the same as the MOCVD apparatus shown in Fig. 1.

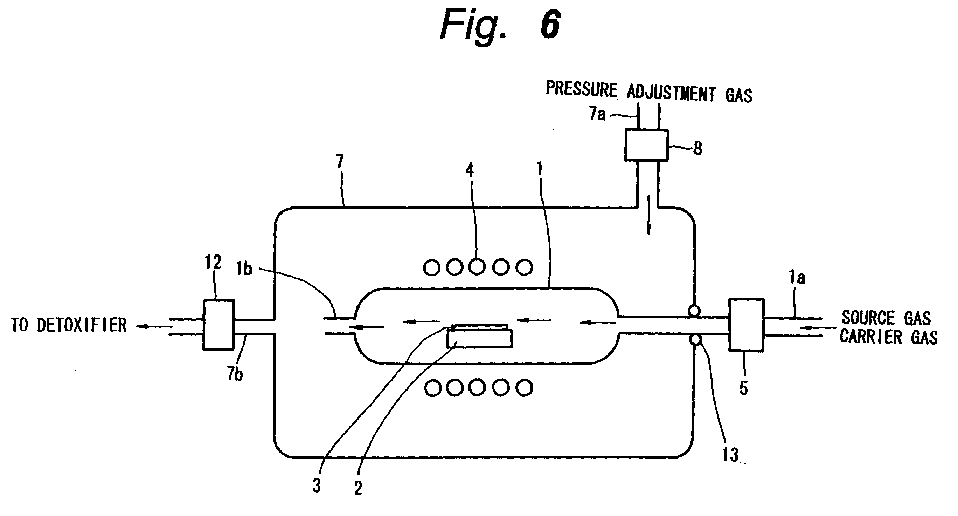

The MOCVD apparatus shown in Fig. 6, unlike the MOCVD apparatus shown in Fig. 2, has a pressure adjuster 12 in the gas outlet 7b and locates the pressure adjuster 5 at a portion of the gas inlet 1a outside the container 7. The gas inlet 1a and the container 7 are fixed to each other via a gasket 1, such as O ring, and are vacuum-sealed. Alternatively, the gas inlet 1a and the container 7 may be welded directly. Usable as the pressure adjuster 12 is any like those examples shown above as being usable as the pressure adjuster 6 in the MOCVD apparatus shown in Fig. 1. In the other respect, the structure shown here is the same as the MOCVD apparatus shown in Fig. 2.

Next explained is a process for growing a GaN semiconductor according to the embodiment of the invention. In this process for growing the GaN semiconductor, any of the MOCVD apparatuses shown in Figs. 1 through 6 may be used.

First set on the susceptor 2 is a substrate 3 for growth. After heating the substrate 3, the pressure in the reaction tube 1 is set to a value not lower than 1.1 atmospheres and not higher than two atmospheres, namely 1.2 atmospheres, for example. After that, by supplying necessary source gas together with a carrier gas into the reaction tube 1 through the gas inlet 1a, a GaN semiconductor is grown on the substrate 3. The substrate 3 may be a c-face sapphire substrate or SiC substrate, for example. The source gas may contain, for example, trimethyl gallium (TMG) as a Ga source, trimethyl aluminum (TMA) as an Al source, trimethyl indium (TMIn) as an In source, ammonia (NH₃) as a N source, silane (SiH₄) as an n-type impurity dopant, and cyclopentadienile magnesium (Cp₂Mg) as a p-type impurity dopant. The temperature is set to approximately 1000°C for growth of a GaN semiconductor not containing In (such as GaN or AlGaN) or approximately 700 to 800°C for growth of a GaN semiconductor containing In (such as GaInN) to minimize decomposition of InN.

When a c-face sapphire substrate is used as the substrate 3, a GaN buffer layer is first grown on the c-face sapphire substrate under a temperature around 560°C before growing other GaN semiconductors in most cases.

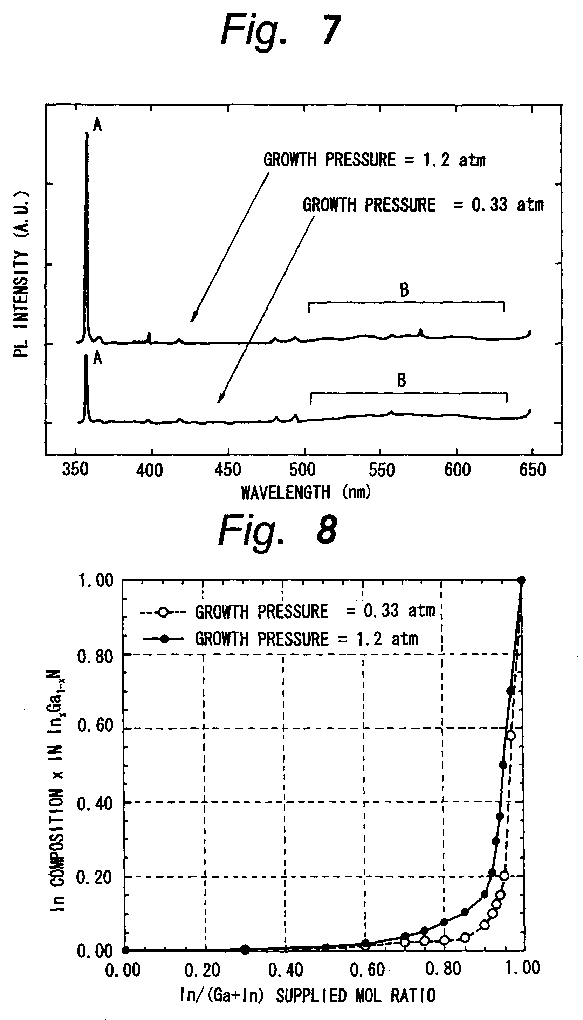

Fig. 7 shows a result of photoluminescent spectral measurement made under 77K on GaN films grown by setting the pressure in the reaction tube 1 to 1.2 atmospheres and 0.33 atmospheres, respectively. The samples used for measurement were prepared by growing a GaN film on a c-face sapphire substrate via a GaN buffer layer, respectively. In Fig. 7, peaks shown at A are emission components called band-edge emission. It is generally believed that the larger the intensity of the peak A, the better the crystallographic property. In Fig. 7, B denotes emission components by emission from deep levels. It is generally believed that the smaller the intensity of B, the better the crystallographic property. It is known from Fig. 7 that the GaN film grown under 1.2 atmospheres exhibits larger band-edge emission and smaller emission from deep levels than the GaN film grown under 0.33 atmospheres. This experimental results mean that the crystallographic property of a GaN film is improved by growing GaN under a higher pressure in the reaction tube 1.

Other samples were prepared by growing an AlGaN film on a c-face sapphire substrate via a GaN buffer layer and by setting the pressure in the reaction tube 1 to 1.2 atmospheres 0.33 atmospheres, respectively, and these AlGaN films were observed through an optical microscope. It has been known that AlGaN films occasionally include cracks along their surfaces, and such cracks appeared on the sample having the AlGaN film grown at 0.33 atmospheres. In contrast, no cracks were observed on the sample having the AlGaN film at 1.2 atmospheres, and the effect by setting the pressure in the reaction tube 1 higher was confirmed.

Fig. 8 is a diagram made by plotting In composition x in InₓGa₁₋ₓN grown by setting the pressure in the reaction tube 1 to 1.2 atmospheres and 0.33 atmospheres relative to the In/(Ga+In) mol ratio in the source materials supplied into the reaction tube 1. It is known from Fig. 8 that the film grown at 1.2 atmospheres incorporates In more efficiently by a less In/(Ga+In) supplied mol ratio than the film grown at 0.33 atmospheres. This is important especially for growing an InₓGa₁₋ₓN layer used as the active layer of a GaN-based light emitting device, and also from this viewpoint, growth by setting the pressure in the reaction tube 1 higher is advantageous.

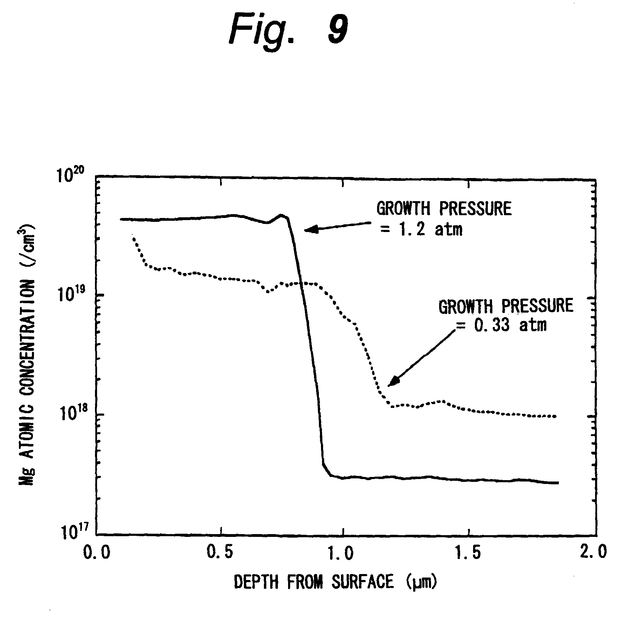

Fig. 9 is a diagram showing a result of measurement of the concentration of Mg atoms through secondary ion mass spectrometry (SIMS) in Mg-doped GaN samples grown by setting the pressure in the reaction tube 1 at 1.2 atmospheres and 0.33 atmospheres, respectively. In both samples, undoped GaN of approximately 1 µm was first grown on a c-face sapphire substrate via a GaN buffer layer, and Mg-doped GaN of approximately 1 µm was grown consecutively. Since the layer deeper than 1 µm from the surface is undoped, it could not contain Mg, but Fig. 9 shows that the undoped layer also contains Mg due to diffusion of Mg from the superficial Mg-doped layer. However, when growth is made at 1.2 atmospheres, the decrease in Mg concentration in the boundary between the Mg-doped layer and the undoped layer is more steep, and the undoped layer contains a small amount of Mg. In contrast, when the growth is made at 0.33 atmospheres, the decrease in Mg concentration is moderate, and the undoped layer contains a more amount of Mg. This suggests that growth at 1.2 atmospheres suppresses diffusion of Mg whereas growth at 0.33 atmospheres results in permitting a larger amount of Mg to diffuse into the undoped layer. Considering that such diffusion is a phenomenon unlikely to occur when the crystallographic property is good, Fig. 9 shows that a higher growth pressure contributes to improvement of the crystallographic property. It is important to make a steep changing boundary by minimizing such diffusion when fabricating a device, and a higher growth pressure is advantageous also from this standpoint.

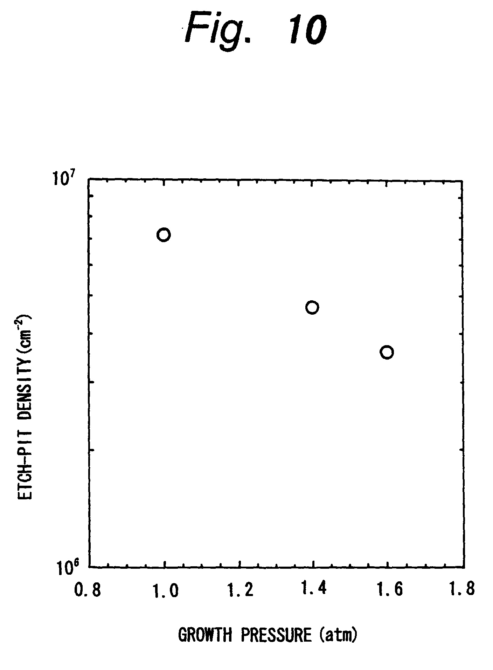

Fig. 10 is a diagram in which, as to GaN samples grown by setting the pressure in the reaction tube 1 to 1.0, 1.4 and 1.6 atmospheres, densities of pits appearing along surfaces as a result of etching (etch-pit densities) relative to the growth pressure are plotted. It is recognized from Fig. 10 that the etch-pit density of the GaN sample grown at 1.6 atmospheres is about 3.5x10⁶cm⁻² which is approximately ½ of the etch-pit density, 7.2x10⁶cm⁻², of the GaN sample grown at 1.0 atmosphere. The etch-pit density has a close relation to the density of crystalline defects. In general, the lower the etch-pit density, the lower the density of defects, namely, the better the crystallographic property. Therefore, the GaN sample grown at 1.6 atmospheres has a better crystallographic property than the GaN sample grown at 1.0 atmosphere. In this respect, growth at 1.6 atmospheres is more advantageous than growth at 1.0 atmosphere.

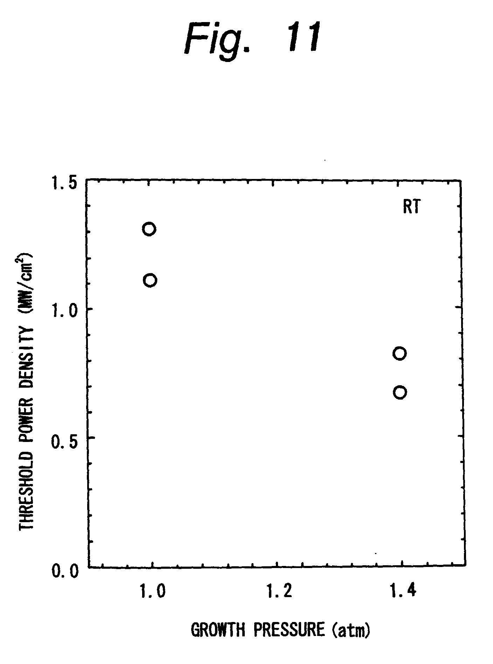

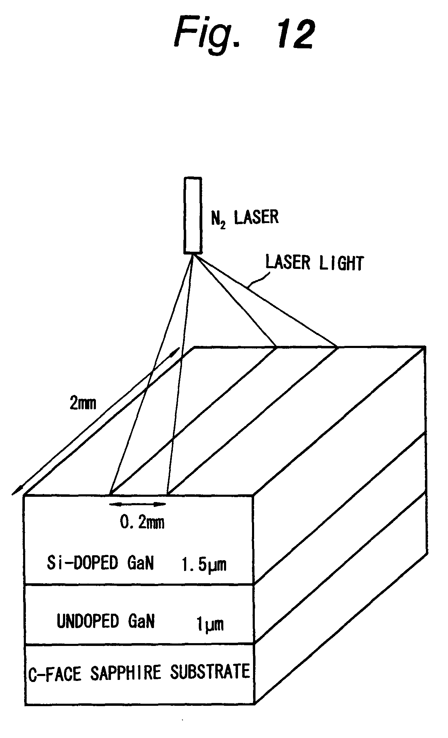

Fig. 11 is a diagram in which threshold power densities of stimulated emission by photo excitation relative to growth temperature are plotted on Si-doped GaN samples grown by setting the pressure in the reaction tube 1 to 1.0 and 1.4 atmospheres. The threshold power density herein means the power density of minimum excited light enough to effectuate stimulated emission of light from each sample (optical power per unit area). The stimulated emission test was conducted under the arrangement shown in Fig. 12, by irradiating laser light by a nitrogen laser onto upper surfaces of the samples. It is recognized from Fig. 11 that the Si-doped GaN sample grown at 1.4 atmospheres has a lower threshold power density than that of the Si-doped GaN sample grown at 1.0 atmospheres. The low threshold power density indicates that the crystal has less crystalline defects or other factors which do not contribute to or do prevent emission of light, and it can be an evidence of a higher crystallographic property. Additionally, the fact that a low threshold power density is confirmed in the test permits the estimation that the threshold current will be lower also in a current-injection semiconductor laser. In this sense, a higher growth temperature is considered more preferable.

Next explained is a method for manufacturing a GaN semiconductor laser, using a method for growing a GaN semiconductor according to an embodiment of the invention. In the method for growing a GaN semiconductor shown here, one of the MOCVD apparatuses shown in Figs. 1 to 6 is used to grow the GaN semiconductor, and a c-face sapphire substrate is used as the substrate 3 for growth thereon.

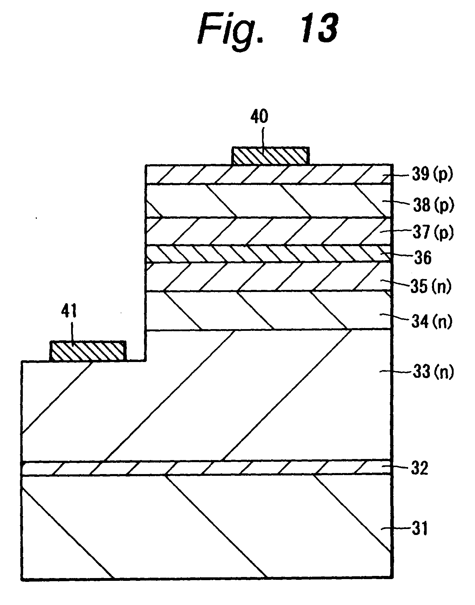

The c-face sapphire substrate is first set on the susceptor 2, and heated to a growth temperature. Thereafter, the pressure in the reaction tube 1 is set to a value not lower than 1.1 atmospheres and not higher than 2 atmospheres, namely 1.2 atmospheres, for example. Then, the growth is started by supplying a necessary source gas together with a carrier gas into the reaction tube 1 through the gas inlet 1a. In this case, a GaN buffer layer is first grown on the c-face sapphire substrate under a low temperature around 560°C, and GaN semiconductors are grown thereafter. That is, as shown in Fig. 13, sequentially grown on the GaN buffer layer 32 grown on the c-face sapphire substrate 31 are an n-type GaN contact layer 33, n-type AlGaN cladding layer 34, n-type GaN optical guide layer 35, active layer 36 having a Ga₁₋ₓInₓN/Ga_{1-y}In_{y}N multi-quantum well structure, p-type GaN optical guide layer 37, p-type AlGaN cladding layer 38 and p-type GaN contact layer 39. The source gas may contain, for example, TMC as a Ga source, TMA as an Al source, TMIn as an In source, NH₃ as a N source, SiH₄ as an n-type impurity dopant, and Cp₂Mg as a p-type impurity dopant. The temperature is set to approximately 1000°C for growth of GaN semiconductors not containing In, namely, GaN contact layer 33, n-type AlGaN cladding layer 34, n-type GaN optical guide layer 35, p-type GaN optical guide layer 37, p-type AlGaN cladding layer 38 and p-type GaN contact layer 39, and to approximately 700 to 800°C for growth of the layer containing In, namely, the active layer 36 having a Ga₁₋ₓInₓN/Ga_{1-y}In_{y}N multi-quantum well structure, to minimize decomposition of InN. After that, the structure is annealed to electrically activate the p-type impurities doped into the p-type GaN optical guide layer 37, p-type AlGaN cladding layer 38 and p-type GaN contact layer 39.

A predetermined stripe-shaped resist pattern (not shown) is next formed on the p-type GaN contact layer 39. Using the resist pattern as a mask, layers are selectively removed by etching by reactive ion etching (RIE) to the depth reaching the n-type GaN contact layer 33. Then, after removing the resist pattern, a p-side electrode 40 having a multi-layered structure of Ni/Au or Ni/Pt/Au, for example, is formed on the p-type GaN contact layer 39, and an n-side electrode 41 of a Ti/Al structure, for example, is formed on the n-type GaN contact layer 33 exposed by etching. Thus, the intended GaN semiconductor laser is obtained.

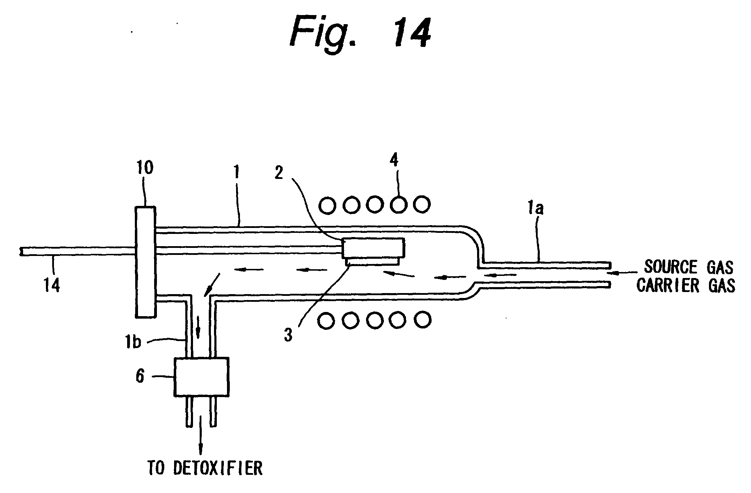

In the MOCVD apparatuses shown in Figs. 1 through 6, the substrates is set to orient its surface for growth of GaN semiconductors upward. However, the surface of the substrate 3 may be oriented downward, and such orientation contributes to unique effects explained below. Fig. 14 shows a MOCVD apparatus configured to hold the substrates upside down during growth.

As shown in Fig. 14, in the MOCVD apparatus, the down stream end of the reaction tube 1 is sealed by a high pressure-resistant flange 10. The high pressure-resistant flange 10 supports a susceptor supporter 14. A susceptor 2 is attached to one end of the susceptor supporter 14 inside the reaction tube 1 so that the substrate 3 be fixed to the lower surface of the susceptor 2 to orient the surface for growth downward. A gas outlet 1b extends outward from a position of the bottom of the reaction tube 1 nearest to the high pressure-resistant flange 10. A pressure adjuster 6 is interposed in the gas outlet 1b. In the other respect, the structure shown here is the same as the MOCVD apparatus shown in Fig. 1.

Also in the MOCVD apparatus shown in Fig. 14, the source gas and the carrier gas are introduced into the reaction tube 1 through the gas inlet 1a and heated near the susceptor 2, and reaction occurs and GaN semiconductors deposit on the surface of the substrate 3, in the same manner as in the MOCVD apparatuses shown in Figs. 1 to 6. However, the MOCVD apparatus shown here is different from those shown in Figs. 1 to 6 in that the substrate 3 is held upside down and that the source gas and the carrier gas are supplied onto the downward-oriented surface of the substrate. In the structure shown here, since an ascending current toward the surface of the substrate 3 is produced due to thermal convection, the source gas is efficiently supplied to the surface of the substrate 3.

Next explained are some modes of fixing the substrate 3 to the lower surface of the susceptor 2 to orient the surface downward.

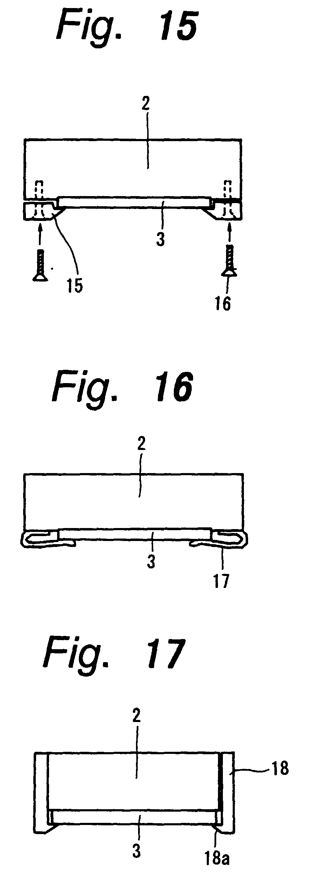

In the example shown in Fig. 15, a substrate holder 15 engageable with the circumferential margin of the substrate 3 is applied from the lower direction onto the surface of the substrate 3 to press it to the lower surface of the susceptor 2, and the substrate holder 15 is fixed to the susceptor 2 by screws 16 to hold the substrate 3 on the lower surface of the susceptor 2. The substrate holder 15 used here may be configured appropriately, to engage the surface of the substrate 3 over its full circumferential length, to engage it only at some portions like hooks, or in other various modes.

In the example shown in Fig. 16, springs 17 are provided at lower portions of the susceptor 2 to fix the substrate 3 onto the lower surface of the susceptor 2 by tightly engaging circumferential edge portions of its surface.

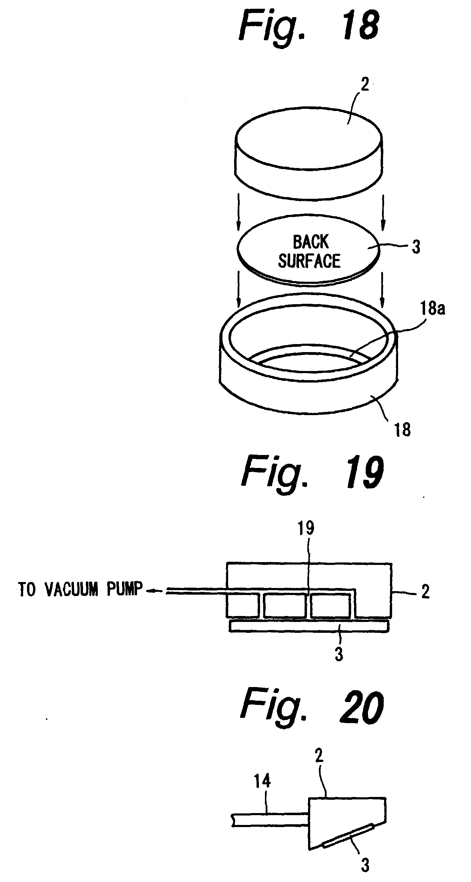

In the example shown in Fig. 17, a cylindrical frame 18 having a diameter slightly larger than the diameter of the substrate 3 and having a substrate support 18a is used to fix the substrate 3 onto the lower surface of the susceptor 2 by putting the substrate 3 in the frame 18 and by inserting the susceptor 2 inside the frame 18, as shown in Fig. 18 in a perspective view.

In the example shown in Fig. 19, the susceptor 2 has formed small evacuation paths opening onto the lower surface thereof to make a vacuum chuck which attracts the substrate 3 onto the lower surface of the susceptor 2 when the evacuation paths 19 are evacuated by a vacuum pump. The degree of the evacuation is appropriately determined not to adversely affect the flow of the source gas and the carrier gas.

Although Fig. 14 illustrates the substrate 3 as being held to orient its surface straightly downward, the surface for growing GaN semiconductors thereon may be held in an orientation for a normal to the surface to have a downword component, that is, the surface may be oriented obliquely downward as shown in Fig. 20.

Here are shown exemplary conditions for growth of GaN semiconductors onto the surface of the substrate 3 oriented downward. That is, by supplying TMG as the Ga source in the flow rate of 25 µmol per minute and NH₃ as the N source in the flow rate of 0.1 mol per minute, GaN films having excellent crystallographic properties can be grown. Considering that the typical flow rate of NH₃ is 0.2 to 0.3 mol per minute relative to the flow rate of TMG being 25 µmol per minute for growth onto the surface of the substrate 3 oriented upward, downward orientation of the substrate surface promises efficient growth of GaN films with good crystallographic property with a less supply amount of NH₃.

As described above, according to the embodiment, by growing the GaN semiconductor in the reaction tube 1 set to a pressure not lower than 1.1 atmospheres and not higher than two atmospheres, a more amount of nitrogen source material as much as the increase of the pressure in the reaction tube is supplied onto the substrate, and vaporization of nitrogen from the GaN semiconductor film grown on the substrate is suppressed as compared with the conventional growth in a reaction tube set to ordinary pressure or a reduced pressure. Therefore, a high-quality GaN semiconductor film can be grown, removing the problem of insufficient nitrogen in the GaN semiconductor layer.

Additionally, downward orientation of the surface of the substrate 3 during growth of GaN semiconductors promises particular advantages explained below. When a GaN semiconductor is grown by MOCVD, a high growth temperature is required, and a large ascending current is produced by thermal convection on the substrate 3 when held to orient its surface upward. There arises the possibility that the source gas is difficult to reach effectively onto the substrate 3 and that N or other elements may vaporize from the crystal once grown, and these factors prevents improvements in growth efficiency relative to the supply of the source gas and in crystallographic property. In contrast, when the substrate 3 is held to orient its surface downward during growth, the ascending current by thermal convection runs just toward the surface. Therefore, the source gas is effectively brought onto the surface of the substrate 3 by the ascending current. It results in effectively increasing the concentration of the source gas near the surface of the substrate 3, efficiently promoting the growth, alleviating vaporization of N or other elements so much as the nitrogen pressure is largely added, and improving the quality of the crystal. Especially under the condition used here, where the pressure in the reaction tube 1 is set higher than the atmospheric pressure during growth, not only the improvement in the crystal quality by a higher growth pressure but also the improvements in growth efficiency and crystallographic property by downward orientation of the surface of the substrate 3 contribute to growth of GaN semiconductor films with much higher qualities.

By using the method according to the embodiment, a high-performance, long-life GaN semiconductor laser as shown in Fig. 13 can be realized.

Having described a specific preferred embodiment of the present invention with reference to the accompanying drawings, it is to be understood that the invention is not limited to that precise embodiment, and that various changes and modifications may be effected therein by one skilled in the art without departing from the scope or the spirit of the invention as defined in the appended claims.

For example, MOCVD apparatuses shown in Figs. 1 through 6 and Fig. 14 are only examples, and any other MOCVD apparatus having a construction different from them may be used. Namely, for example, the susceptor 2 may be heated by a lamp or an electric furnace.

As described above, according to the invention, by growing a nitride III-V compound semiconductor in a reaction tube with an inner pressure set to a value not lower than 1.1 atmospheres, the problem of insufficient nitrogen of the nitride III-V compound semiconductor grown can be solved, indium, for example, can be incorporated into the nitride III-V compound semiconductor grown efficiently, steep impurity concentration profile can be obtained and good crystallographic property can be obtained. As a result, a high-quality nitride III-V compound semiconductor can be grown efficiently.

## Claims

1. A method for growing a nitride III-V compound semiconductor by metal-organic chemical vapor deposition, comprising:
growing said nitride III-V compound semiconductor in a reaction tube whose inner pressure is set to a value not lower than 1.1 atmospheres.

2. The method for growing a nitride III-V compound semiconductor according to claim 1 wherein said inner pressure of the reaction tube is set to a value not lower than 1.1 atmospheres and not higher than two atmospheres.

3. The method for growing a nitride III-V compound semiconductor according to claim 1 wherein said inner pressure of the reaction tube is set to a value not lower than 1.2 atmospheres and not higher than 1.8 atmospheres.

4. The method for growing a nitride III-V compound semiconductor according to claim 1 wherein said inner pressure of the reaction tube is set to a value not lower than 1.4 atmospheres and not higher than 1.8 atmospheres.

5. The method for growing a nitride III-V compound semiconductor according to claim 1 wherein said inner pressure of the reaction tube is set to a value not lower than 1.6 atmospheres and not higher than 1.8 atmospheres.

6. The method for growing a nitride III-V compound semiconductor wherein a surface of a substrate on which said nitride III-V compound semiconductor is to be grown is oriented downward.

7. An apparatus for growing a nitride III-V compound semiconductor by metal-organic chemical vapor deposition, comprising a reaction tube whose inner pressure is set to a value not lower than 1.1 atmospheres for growing said nitride compound semiconductor.

8. The apparatus for growing a nitride III-V compound semiconductor according to claim 7 wherein a substrate having a surface for growing said nitride III-V compound semiconductor thereon is held in an orientation for a normal to said surface to have a downward component.
